# EUROPEAN PATENT APPLICATION

(11) **EP 4 583 239 A1**
(43) Date of publication of application: **09.07.2025**
(21) Application number: 24223499.5
(22) Date of filing: 27.12.2024
(51) Int. Cl.: H01M 10/42, H01M 10/48, H01M 50/204, H01M 50/284, H01M 50/298, H01M 50/507, H01M 50/519, H01M 50/583

(54) **BATTERY PACK**

(30) Priority: 04.01.2024 KR 20240001519
(71) Applicant: SAMSUNG SDI CO., LTD., Yongin-si, Gyeonggi-do 17084 (KR)
(72) Inventor: Park, Kyunghoon, 17084 Yongin-si, Gyeonggi-do (KR)
(74) Representative: Gulde & Partner

(57) **Abstract**

A battery pack includes a battery module including battery cells, and busbars electrically connecting respective ones of the battery cells, and a circuit board connected to the battery module, and including a first part including wires, and extending in a length direction of the battery module, second parts extending from the first part in a direction crossing the first part, and including a circuit pattern including a fuse pattern configured to be opened based on an abnormal current, and a non-fuse pattern configured to maintain electrical connection with one or more of the busbars, and third parts respectively extending from the second parts, and connected to the busbars.

## Description

### BACKGROUND

### 1. Field

The present disclosure relates to a battery pack.

### 2. Description of the Related Art

Secondary batteries are designed to be rechargeable, and may be used as energy sources of devices, such as mobile devices, electric vehicles, hybrid electric vehicles, electric bicycles, or uninterruptible power supplies. Depending on the type of an external device to which a secondary battery is applied, the secondary battery may be used as a single battery cell, or as a module or pack in which a plurality of battery cells are connected into a unit.

The above-described information is only for enhancement of understanding of the background of the present disclosure, and thus may contain information that does not constitute the related art.

### SUMMARY

A battery pack according to embodiments may enable reuse of a circuit board without replacing all or part of the circuit board, even if a short circuit or an electrostatic discharge (ESD) occurs.

However, the aspects of the present disclosure is not limited to the foregoing, and other unmentioned aspects would be clearly understood by those of skill in the art from the following description.

Additional aspects will be set forth in part in the description that follows and, in part, will be apparent from the description, or may be learned by practice of the presented embodiments of the present disclosure.

According to one or more embodiments, a battery pack includes a battery module including battery cells, and busbars electrically connecting respective ones of the battery cells, and a circuit board connected to the battery module, and including a first part including wires, and extending in a length direction of the battery module, second parts extending from the first part in a direction crossing the first part, and including a circuit pattern including a fuse pattern configured to be opened (e.g. melted, disrupted) based on an abnormal current, and a non-fuse pattern configured to maintain electrical connection with one or more of the busbars, and third parts respectively extending from the second parts, and connected to the busbars.

A width of the fuse pattern may be less than a width of the non-fuse pattern.

The width of the fuse pattern may be 20% to 60% of the width of the non-fuse pattern.

An open time of the fuse pattern during which the fuse pattern ruptures based on the abnormal current through the circuit pattern may be less (shorter) than or equal to half of an open time of the non-fuse pattern.

The fuse pattern and the non-fuse pattern may be spaced apart from a central portion of the second part in a width direction of the second part.

One of the second parts may further include a connection area at an end thereof that is connected to the fuse pattern, to the non-fuse pattern, and to the third part.

The circuit pattern may further include a block pattern between the fuse pattern and the non-fuse pattern that is configured to block an arc generated due to the fuse pattern being opened.

The block pattern may be spaced apart from the fuse pattern, from the non-fuse pattern, and from the connection area, and may be electrically separated from the wires.

The first part may further include first guides respectively on both sides thereof in a width direction of the first part, wherein the second part further includes two second guides respectively on both sides thereof in a width direction of the second part, and extending from or spaced apart from the first guides with the circuit pattern between the two second guides.

The first guides may protrude higher than an upper surface of the first part on which the wires are arranged, wherein the second guides protrude higher than an upper surface of the second part where the circuit pattern is arranged.

An empty safety area may be defined between the second guides and the fuse pattern, and between the fuse pattern and the block pattern.

A width of the safety area may be 30% to 40% of a width between the two second guides.

The second guides may extend further toward the third part than the fuse pattern and the non-fuse pattern, and may overlap the connection area in the width direction of the second part.

The fuse pattern may include a bent portion having a wavy shape, and extending portions respectively connected to both ends of the bent portion in a length direction, and connecting the bent portion to the first part and the third part, respectively.

The bent portion may have a shape in which convex portions and concave portions are continuous at equal intervals, and a distance between adjecent ridges is 1.5 times to 3 times a total width of the bent portion.

The bent portion of the fuse pattern may comprise or consists of a swellable material.

### BRIEF DESCRIPTION OF THE DRAWINGS

The above and other aspects embodiments of the present disclosure will be more apparent from the following description taken in conjunction with the accompanying drawings. The accompanying drawings illustrate embodiments of the present disclosure, and together with the description of the present disclosure to be provided below, serve to provide further understanding of aspects of the present disclosure. The present disclosure is not to be construed as being limited to the drawings.
FIG. 1 illustrates a vehicle including a battery pack;
FIG. 2 is an exploded perspective view of a battery pack;
FIG. 3 is an enlarged view of a portion of a battery pack;
FIG. 4 is an enlarged view of a portion of a circuit board;
FIG. 5 is an enlarged view of area V of FIG. 4;
FIG. 6 illustrates a fuse pattern before expansion; and
FIG. 7 illustrates a fuse pattern after expansion.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions, such as "at least one of," if preceding a list of elements, modify the entire list of elements and do not modify the individual elements of the list.

Some embodiments of the present disclosure and methods according thereto may be understood by referring to the detailed descriptions and drawings of the embodiments. The described embodiments may have various modifications and may be embodied in different forms, and are not limited to the embodiments described herein. In addition, some or all of features of various embodiments of the present disclosure may be combined with each other. The embodiments may be implemented independently or in relation to each other. The described embodiments are provided as examples for ensuring that the present disclosure is complete, and are also intended to completely convey the scope of the present disclosure to those of skill in the art to which the present disclosure pertains. The present disclosure is subject to all modifications, equivalents, and substitutions within the technical scope of the present disclosure. Thus, processes, elements, and techniques that are not necessary to those of skill in the art for a complete understanding of the embodiments of the present disclosure may not be described.

Unless otherwise noted throughout the accompanying drawings and the specification, the same reference numerals, letters, or combinations thereof indicate the same elements, and thus, redundant descriptions thereof will be omitted. In addition, in order to clearly describe the present disclosure, parts irrelevant to the description will be omitted.

Relative sizes of elements, layers, and regions in the drawings may be exaggerated for clarity. The use of hatching and/or shading in the accompanying drawings generally serves to clarify boundaries between adjacent elements. Thus, neither the presence nor the absence of hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to cross-sectional examples that are schematic illustrations of embodiments and/or intermediate structures. Thus, the shapes of the drawings may vary, for example, as a result of manufacturing techniques and/or tolerances. In addition, specific structural or functional descriptions disclosed herein are merely illustrative for the purpose of describing embodiments according to the concept of the present disclosure. Thus, embodiments disclosed herein should not be construed as limited to the particular illustrated shapes of regions, but are to include deviations in shapes that result from, for example, manufacturing.

The regions illustrated in the drawings are schematic in nature and their shapes are not intended to illustrate the actual shape of a region of a device and are not intended to be limiting. In addition, as those of skill in the art would realize, the described embodiments may be modified in various different ways without departing from the scope of the present disclosure.

Numerous particular details are set forth in the specification to provide a thorough understanding of various embodiments. It is apparent, however, that various embodiments may be practiced without these particular details or with one or more thereof. In other instances, well-known structures and devices are shown in a block diagram form in order to avoid unnecessarily obscuring various embodiments.

Spatially relative terms, such as "below," "on," "lower," "upper," and the like, may be used herein for ease of explanation to describe one element or feature's relationship to another element or feature as illustrated in the drawings. The spatially relative terms are intended to encompass different orientations of the device in use or in operation, in addition to the orientation depicted in the drawings. For example, if the device in the drawings is turned over, elements described as being "below" or "lower" is oriented "on" another element or feature. Thus, the example terms "below" and "lower" may encompass both orientations of "above" and "lower". The device may be otherwise oriented (e.g., rotated 90 degrees or at other orientations) and the spatially relative descriptors used herein should be interpreted accordingly. Similarly, if a first part is described as being arranged "on" a second part, this indicates that the first part is arranged at an upper side or a lower side of the second part.

In addition, the expression "viewed from a plane" refers to a view of an object part from above, and the expression "in a schematic cross-sectional view" refers to a schematic cross-section taken along a vertical line passing through the object part. The expression "viewed from a side" means that a first object may be above, below, or to the side of a second object and vice versa. In addition, the term "overlapping" may refer to layers, a stack, surfaces, extension, covering, partially covering, or any other suitable terms that would be understood by those of skill in the art. The expression "does not overlap" may include meanings, such as "apart from," "separated from," or any other suitable equivalents recognized and understood by those of skill in the art. The terms "face" and "surface" may mean that a first object may directly or indirectly face a second object. If a third object is between a first object and a second object, it may be understood that the first object and the second object face each other but indirectly oppose each other.

If an element, layer, region, or component is referred to as being "formed on," "connected to," or "coupled to" another device, it may be directly formed on, a layer, region, or component, formed on another component, layer, region, or component, or indirectly formed on, connected to, or coupled to another component. In addition, this may collectively mean direct or indirect coupling or connection and integral or non-integral coupling or connection of one or more elements, layers, regions, or components to enable the presence of the elements, layers, regions, or components. For example, if an element, layer, region, or component is referred to as being "electrically connected" or "electrically coupled" to another element, layer, region, or component, they may be directly electrically connected or coupled to each other, or other elements, layers, regions, or components may be present. However, "directly connected" or "directly coupled" refers to one component being directly connected or coupled to another component without an intermediate component, or being on the other component. In addition, in the specification, if part of a layer, film, region, plate, etc. is formed on another part, the formation direction is not limited to the upward direction, and encompasses that the part is formed on a side surface or a lower portion of the other part. On the contrary, if part of a layer, film, region, plate, etc. is formed "below" another part, the part may be "immediately below" the other part, or another part may be present between the part and the other part. In addition, other expressions describing relationships between components, such as "between," "immediately between," "adjacent to," or "directly adjacent to," may be construed similarly. In addition, if an element or layer is referred to as being "between" two elements or layers, it may be the only element or layer between the two elements or layers, or one or more intervening elements or layers may be present between the two elements or layers.

For the purposes of the specification, expressions, such as "at least one of," "any one" do not limit the order of individual elements. For example, "at least one of X, Y, and Z," "at least one of X, Y, or Z," and "at least one selected from the group consisting of X, Y, and Z" may be construed as X only, Y only, Z only, any combination of two or more of X, Y, and Z. Similarly, an expression, such as "at least one of A and B" or "at least one of A or B" may include A, B, or A and B. As used herein, the term "and/or" includes any and all combinations of one or more of the associated listed items. For example, an expression, such as "A and/or B" may include A, B, or A and B.

Although the terms "first," "second," or "third," etc., may be used herein to describe various elements, components, regions, layers, and/or cross sections, these elements, components, regions, layers and/or sections are not limited by these terms. These terms are used to distinguish one element, component, region, layer, or cross section from another element, component, region, layer, or cross section. Thus, a first element, component, region, layer, or cross section described below may be referred to as a second element, component, region, layer, or cross section, without departing from the scope of the present disclosure. The description of an element as a "first" element may not require or imply the presence of a second element or other elements. The terms "first," "second," etc. may also be used herein to differentiate different categories or sets of elements. For clarity, the terms "first," "second," etc. may refer to a "first category (or first set)," a "second category (or second set)," etc., respectively.

Terms used herein are merely used to describe a particular embodiment, and are not intended to limit the present disclosure. As used herein, singular terms are intended to include plural terms, and plural terms are also intended to include singular terms, unless the context clearly indicates otherwise. The terms "include" and "have," if used in the specification, specify the presence of the stated features, integers, and steps. These expressions do not exclude the presence or addition of one or more other functions, steps, operations, components, and/or groups thereof.

If one or more embodiments may be implemented differently, particular processes may be performed in a sequence different from the described sequence. For example, two processes, which are successively described herein, may be substantially simultaneously performed, or may be performed in a sequence opposite to the described sequence.

As used herein, the terms "substantially" and "about," and similar terms are used as terms of approximation and not as terms of degree, and are intended to account for the inherent deviations in measured or calculated values that would be recognized by those of skill in the art. As used herein, "about" or "approximately" is inclusive of the stated value and corresponds to an acceptable range of deviation for a particular value determined by those of skill in the art, considering the corresponding measurement and an error associated with the measurement (i.e., a range of deviation due to a limitation of the measurement system). For example, "about" may refer to "within standard deviations" of the stated value.

Unless otherwise defined, all terms, including technical and scientific terms, used herein have the same meaning as commonly understood by those of skill in the art to which the present disclosure pertains based on an understanding of the present disclosure. Terms, such as those defined in commonly used dictionaries, are to be interpreted as having a meaning that is consistent with their meaning in the context of the relevant art and the present disclosure, and are not to be interpreted in an idealized or overly formal sense unless expressly so defined herein.

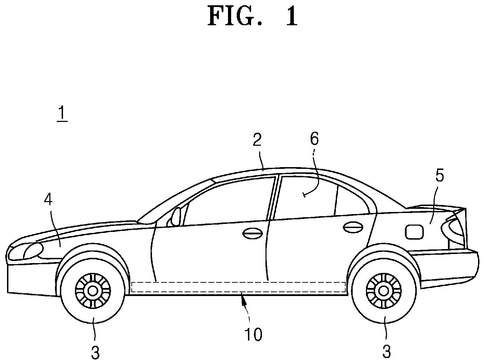

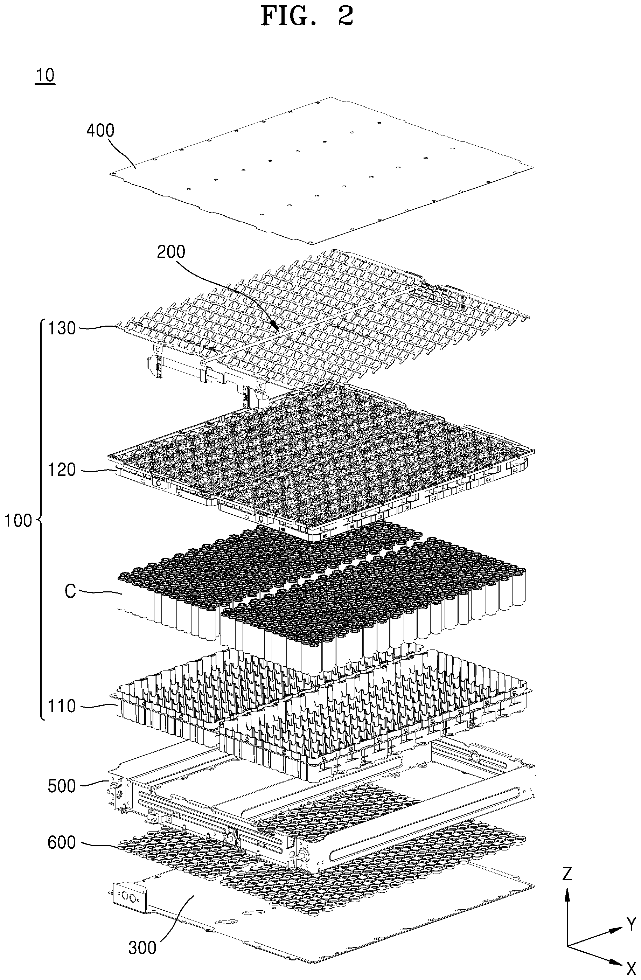

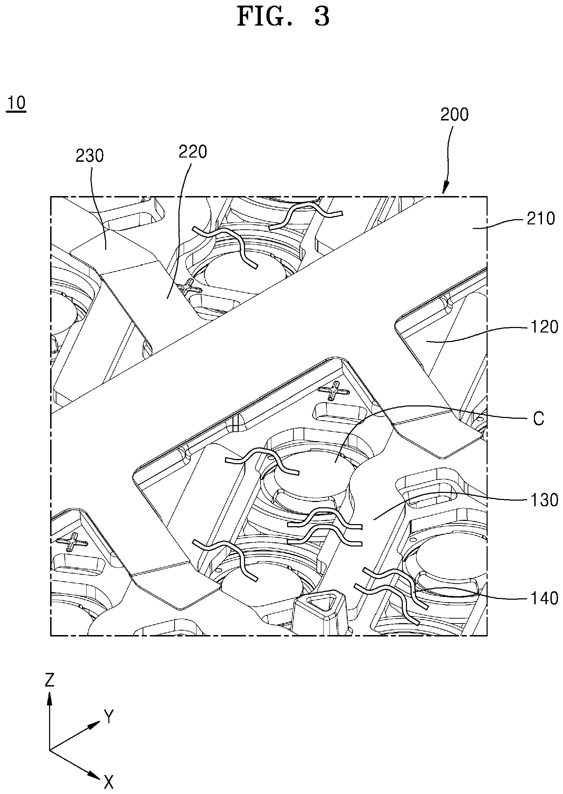

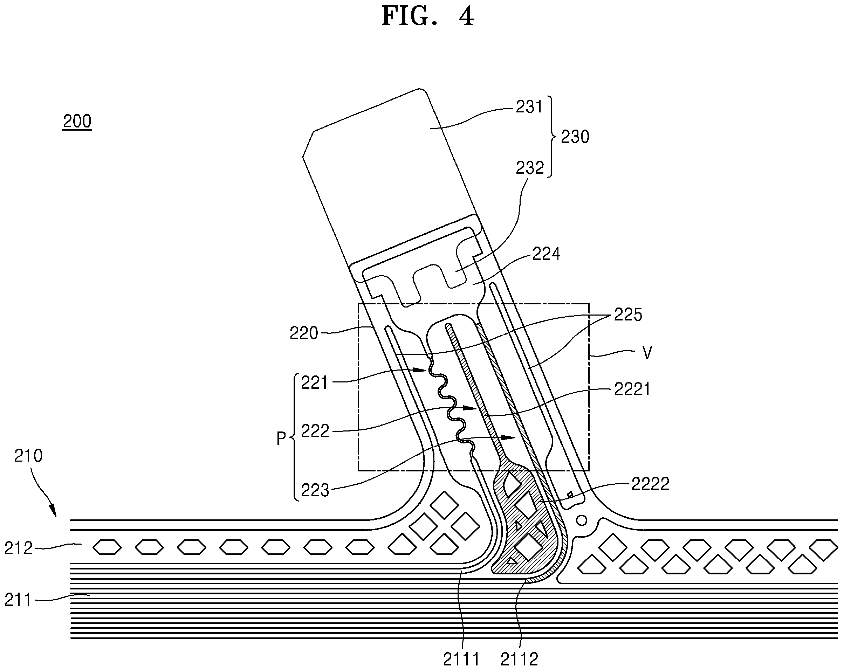

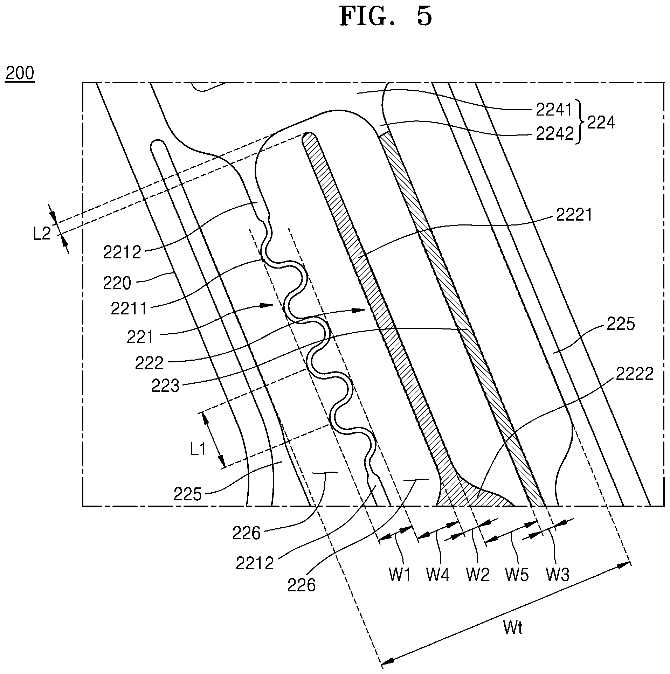

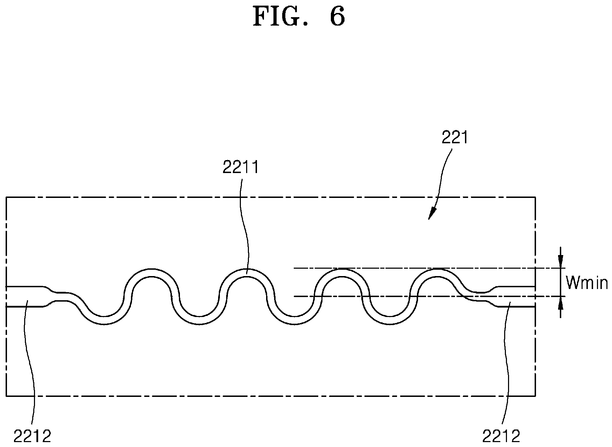

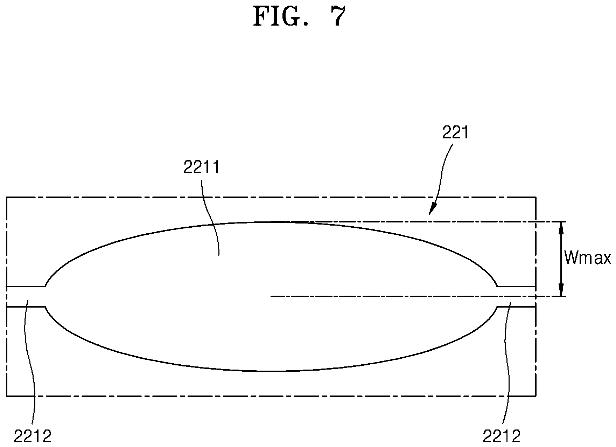

FIG. 1 illustrates a vehicle 1 including a battery pack 10, FIG. 2 is an exploded perspective view of the battery pack 10, FIG. 3 is an enlarged view of a portion of the battery pack 10, FIG. 4 is an enlarged view of a portion of a circuit board 200, FIG. 5 is an enlarged view of area V of FIG. 4, FIG. 6 illustrates a fuse pattern 221 before expansion, and FIG. 7 illustrates the fuse pattern 221 after expansion.

The battery pack 10 includes one or more battery modules 100 and may be applied to various applications. For example, the battery pack 10 may be applied to large-sized applications, such as an energy storage system (ESS), or small-sized and medium-sized applications, such as various electronic devices including power tools. For example, the battery pack 10 may be included in the vehicle 1, referring to FIG. 1. The vehicle 1 may be an electric vehicle, a hybrid vehicle, or a plug-in hybrid vehicle. The vehicle 1 may be a four-wheeled vehicle or a two-wheeled vehicle. The battery pack 10 may be arranged inside a frame 2 of the vehicle 1. For example, referring to FIG. 1, the battery pack 10 may be between a front part 4 and a rear part 5 of the vehicle 1 and between two wheels 3, and may be below an internal space 6 in which a user sits.

The battery pack may include a battery module 100 including a plurality of battery cells C, and busbars 130 electrically connecting the plurality of battery cells C to each other. The circuit board 200 may be connected to the battery module 100. The circuit board 200 may include a first part 210 including a plurality of wires 211 and extending in the length direction of the battery module 100 (or the length direction of the battery pack 10, for example, the Y-axis direction of FIG. 2), may include a plurality of second parts 220 extending from the first part 210 in a direction crossing the first part 210, and including circuit patterns P, and may include third parts 230 extending from the second parts 220 and connected to the busbars 130, respectively. The circuit pattern P may include the fuse pattern 221 that is opened if an abnormal current flows, and a non-fuse pattern 223 that maintains electrical connection with the busbars 130.

The battery pack 10 may include the battery module 100 and the circuit board 200.

One or more battery modules 100 may be included in the battery pack 10. For example, referring to FIG. 2, two battery modules 100 may be included in the battery pack 10. In one or more embodiments, the number of battery modules 100 included in the battery pack 10 is not limited to two, and may be one, three, or more. The battery module 100 may be inside a frame 500 of the battery pack 10, and may be between a lower plate 300 and an upper plate 400. The plurality of battery modules 100 may be spaced apart from each other, and may be electrically connected through the circuit board 200. One or more battery modules 100 may include a plurality of battery cells C. The battery cell C may be cylindrical, angular, or pouch-shaped. Hereinafter, for convenience of description, a case will be mainly described where the battery cell C is cylindrical.

The battery module 100 may include a lower holder 110, an upper holder 120, the busbars 130, and tabs 140.

The lower holder 110, together with the upper holder 120, may accommodate a plurality of battery cells C. The lower holder 110 may be at a lower portion of the battery module 100 and, together with the upper holder 120, may form a space in which the plurality of battery cells C are accommodated. The lower holder 110 may include openings to separately, or individually, accommodate the plurality of battery cells C, respectively. The bottom surface of the lower holder 110 may contact a heat dissipation member 600, and may be inside the frame 500.

The upper holder 120 may be at an upper portion of the battery module 100 and, together with the lower holder 110, may form a space in which the plurality of battery cells C are accommodated. The upper holder 120 may include openings to separately, or individually, accommodate the plurality of battery cells C, respectively. The openings of the upper holder 120 may correspond to the openings of the lower holder 110, respectively. In a state where the plurality of battery cells C are inserted into the upper holder 120, upper ends of the battery cells C may be exposed to the outside through the openings of the upper holder 120, and may be connected to the busbars 130 through the tabs 140. The busbars 130 may be on the upper holder 120, and the tabs 140 may connect the battery cells C to the busbars 130, respectively. The numbers of lower holders 110 and upper holders 120 may be equal to the number of battery modules 100.

The busbars 130 may be connected to the plurality of battery cells C. For example, referring to FIGS. 2 and 3, the busbars 130 may be on the upper holder 120, and may be electrically connected to the plurality of battery cells C and to the tabs 140. The busbars 130 may extend between the plurality of battery cells C (e.g., in plan view), such that upper portions of the plurality of battery cells C are exposed through the openings of the upper holder 120. The busbar 130 may include a conductive material, such as metal. One busbar 130 may be included in one battery module 100.

The busbars 130 may extend in numerous directions, and may be connected to the plurality of battery cells C, respectively. For example, the busbars 130 may extend both in the length direction of the battery pack 10 (e.g., the Y-axis direction of FIG. 2) and in the width direction of the battery pack 10 (e.g., the X-axis direction of FIG. 2), and may be between the battery cells C.

The tabs 140 may electrically connect the battery cells C to the busbars 130. For example, referring to FIG. 3, one end of the tab 140 may be connected to the busbar 130, and the other end may be connected to the battery cell C. The tab 140 may include a conductive material, such as metal, and may have the shape of a wire of which one or more sections are bent. For example, a plurality of tabs 140 may be provided. One battery cell C may be connected to one or more tabs 140. For example, referring to FIG. 3, two tabs 140 may be connected to one battery cell C. One end of a tab 140 may be connected to the upper surface of a corresponding battery cell C, and the other end of the tab 140 may be connected to the upper surface of the busbar 130. One end of another tab 140 may be connected to an upper edge of the corresponding battery cell C, and the other end may be connected to the upper surface of the busbar 130.

The circuit board 200 may be connected to the busbar 130 to detect the state of each battery module 100, and to control the battery module 100. For example, the circuit board 200 may be connected to a controller or a battery management system (BMS), and may measure the voltage, temperature, and/or the like of each battery cell C included in the battery module 100, and may deliver a result of the measuring to the BMS. The BMS may control the battery module 100 through the circuit board 200. For example, the circuit board 200 may be a flexible printed circuit assembly (FPCA), and may include a flexible printed circuit board (FPCB) and components mounted on the FPCA.

The circuit board 200 may be between the battery module 100 and the upper plate 400. For example, referring to FIG. 2, the circuit board 200 may be on the battery module 100. A portion of the circuit board 200 (e.g., the first part 210 of the circuit board 200) may be between two adjacent battery modules 100, and another portion of the circuit board 200 (e.g., the second parts 220 and the third parts 230 of the circuit board 200) may be on the battery module 100, and may be connected to the plurality of battery cells C. One or more circuit boards 200 may be included in the battery pack 10.

The circuit board 200 may include the first part 210, the second parts 220, and the third parts 230.

The first part 210 may connect the other portion of the circuit board 200 (e.g., the second parts 220 and the third parts 230) to the controller or BMS. For example, the first part 210 may extend in one direction (e.g., the length direction of the battery pack 10 or the Y-axis direction of FIG. 2 or FIG.3). The first part 210 may be on the battery module 100 and, for example, may be between two adjacent battery modules 100. The first part 210 may be supported by the upper holder 120, and the plurality of second parts 220 and the third parts 230 may extend from the first part 210 to be connected to the busbars 130.

Referring to FIG. 4, the first part 210 may include the wires 211. For example, the first part 210 may include a plurality of wires 211 on the upper surface thereof. The wires 211 may be connected to the fuse patterns 221 and to the non-fuse patterns 223 included in the second parts 220, respectively. For example, the wires 211 may include a first part 2111 and a second part 2112. The first part 2111 may be connected to the fuse pattern 221, and the second part 2112 may be connected to the non-fuse pattern 223. The plurality of wires 211 may extend in the length direction of the first part 210, and may include metal, such as copper, silver, or aluminum. The first part 2111 and the second part 2112 may extend around a block pattern 222 (e.g., an island portion 2222 of the block pattern 222), and may be spaced apart from the island portion 2222 (e.g., in plan view).

The first part 210 may further include a first guide 212. Referring to FIG. 4, the first guide 212 may be at an end in the width direction of the first part 210 to be adjacent to the wires 211. The first guide 212 may extend along the length direction of the first part 210. The first guide 212 may protrude from the upper surface of the first part 210 to form a step with the upper surface of the first part 210 where the wires 211 are arranged. The first guide 212 may define an area where the wires 211 are arranged, and may reduce or prevent the likelihood of the wires 211 deviating from the designated area. The first guide 212 may maintain the positions of the wires 211 such that the wires 211 do not deviate from the first part 210 if the wires 211 swell or deform during an operation of the battery pack 10. The first part 210 may be connected to a second guide 225 of the circuit pattern P of the second part 220. Although only one first guide 212 is illustrated in FIG. 4, another first guide 212 may be arranged on the opposite side in the width direction of the first part 210. The plurality of wires 211 may be between two first guides 212. The first guide 212 may include a nonconductor.

One or more second parts 220 may extend from the first part 210. For example, referring to FIG. 3, a plurality of second parts 220 may extend toward the busbars 130 in a direction crossing the direction in which the first part 210 extends. The third part 230 may be connected to an end of the second part 220, and may be connected to the busbar 130 such that the busbar 130 and the circuit board 200 may be connected to each other.

The second part 220 may include the circuit pattern P.
The circuit pattern P may be electrically connected to the third part 230 to electrically connect the busbar 130 to the circuit board 200. A portion of the circuit pattern P may be connected to the wires 211, and another portion of the circuit pattern P may be physically and/or electrically separated from the wires 211.

The circuit pattern P may include the fuse pattern 221, the block pattern 222, and the non-fuse pattern 223.
The fuse pattern 221 may be connected to any one of the plurality of wires 211, and may be connected to a connection area 224. If an abnormal operation, such as a short circuit or an electrostatic discharge (ESD) occurs in the battery pack 10, the fuse pattern 221 may blow (melt and disconnect) to protect the connected busbar 130 and the BMS, and may open the circuit. The fuse pattern 221 may be between the second guide 225 and the block pattern 222.

The fuse pattern 221 may be opened (melted) earlier than the non-fuse pattern 223. For example, the fuse pattern 221 may have a width that is less than a width of the non-fuse pattern 223. Referring to FIG. 5, the width of the fuse pattern 221 may refer to the width (thickness) of the wire forming a bent portion 2211 of the fuse pattern 221. Thus, if an abnormal current, such as a short circuit or electrical noise, flows through the circuit pattern P, an open time of the fuse pattern 221 may be shorter than an open time of the non-fuse pattern 223. Or in other words, if an abnormal current, such as a short circuit or electrical noise, flows through the circuit pattern P, the fuse pattern 221 may melt and disrupt faster than the non-fuse pattern 223. For example, the width of the fuse pattern 221 may be (about) 20% to (about) 60% of the width of the non-fuse pattern 223. If the width of the fuse pattern 221 is less than (about) 20% of the width of the non-fuse pattern 223, the fuse pattern 221 may rupture too easily/quickly. If the width of the fuse pattern 221 is greater than (about) 60% of the width of the non-fuse pattern 223, the fuse pattern 221 may rupture too late, and may affect the non-fuse pattern 223. For example, if an abnormal current flows in the circuit pattern P, the open time of the fuse pattern 221 (i.e., the time suitable for the fuse pattern 221 to melt, rupture, break, or burst to result in any form of breakage of the fuse pattern 221) may be shorter than or equal to (about) half of the open time of the non-fuse pattern 223.

The fuse pattern 221 may include the bent portion 2211 and an extending portion 2212.

The bent portion 2211 may be between two extending portions 2212, and may be a portion that breaks if an abnormal current occurs, such as an external short circuit, electrical noise, or an ESD. The bent portion 2211 may have a wavy shape. The bent portion 2211 may then include one or more convex portions and one or more concave portions. For example, referring to FIG. 5, the bent portion 2211 may have a wavy shape, such as a sine wave shape. The bent portion 2211 may have a shape in which convex portions and concave portions of corresponding sizes are continuous at equal or different intervals. The distance between adjacent valleys or between adjacent ridges of the bent portion 2211 may be L1. The distance L1 may be greater than an initial width W1 of the bent portion 2211 before expansion. For example, L1 may be between (about) 1.5 times and (about) 3 times the initial width W1. If the distance L1 is less than (about) 1.5 times the initial width W1, the interval between the valleys or ridges of the bent portion 2211 may be significantly low, and the bent portion 2211 may be opened due to interference even if only a slightly abnormal current flows. If L1 is greater than (about) 3 times the initial width W1, the interval between the valleys or ridges of the bent portion 2211 may be significantly high, and the bent portion 2211 may not be opened in an appropriate amount of time.

If an overcurrent flows through the fuse pattern 221, the bent portion 2211 may gradually swell and then break. For example, referring to FIG. 6, the bent portion 2211 may have a width Wmin between a central portion and a ridge or a valley in the width direction. Wmin may be an initial width before expansion. Thereafter, referring to FIG. 7, if an overcurrent flows through the fuse pattern 221, the bent portion 2211 may expand, and the entire bent portion 2211 may be deformed into a lump. The width of the bent portion 2211 may expand to Wmax.

The extending portions 2212 may be connected to both ends of the bent portion 2211 in the length direction, respectively. Any one extending portion 2212 may be connected to the wires 211, and the other extending portion 2212 may be connected to the connection area 224. The width (thickness) of the extending portion 2212 may be greater than the width (thickness) of the bent portion 2211. The extending portion 2212 may connect the bent portion 2211 to the first part 210 and the third part 230.

The block pattern 222 may be between the fuse pattern 221 and the non-fuse pattern 223. The block pattern 222 may be spaced apart from the fuse pattern 221 and from the non-fuse pattern 223. The block pattern 222 may block an arc that occurs if the fuse pattern 221 is opened, and may reduce or prevent the likelihood of the arc affecting the non-fuse pattern 223. The block pattern 222 may be spaced apart from the connection area 224, and an end of the block pattern 222 may be spaced apart from the connection area 224 by a distance L2. The block pattern 222 may be spaced apart from the wires 211 and other circuit patterns P. The block pattern 222 may be separated from the wires 211, the fuse pattern 221, and the non-fuse pattern 223.

The block pattern 222 may include a block portion 2221 and the island portion 2222.

Referring to FIG. 5, the block portion 2221 may be between the fuse pattern 221 and the non-fuse pattern 223, and may extend straight in the length direction of the fuse pattern 221 or the non-fuse pattern 223. The block portion 2221 may have a width W2. The side of the block portion 2221 adjacent to the fuse pattern 221 may be spaced apart from the fuse pattern 221 by a width W4. The side of the block portion 2221 adjacent to the non-fuse pattern 223 may be spaced apart from the non-fuse pattern 223 by a width W5. Areas by which the block portion 2221 and the fuse pattern 221 are spaced apart from each other, and the block portion 2221 and the non-fuse pattern 223 are spaced apart from each other, may form a safety area. The safety area may be a spacing area between the block portion 2221 and the fuse pattern 221, and between the block portion 2221 and the non-fuse pattern 223, to reduce or prevent the likelihood of an arc, which may be generated as the fuse pattern 221 is opened, affecting the non-fuse pattern 223. One end of the block portion 2221 may be connected to the island portion 2222, and the other end may be spaced apart from the connection area 224 by the distance L2. The width W2 of the block portion 2221 may be greater than the thickness of the bent portion 2211 of the fuse pattern 221, and may be greater than or equal to the width (thickness) W3 of the non-fuse pattern 223.

Referring to FIG. 4, the island portion 2222 may be between the fuse pattern 221 and the non-fuse pattern 223, and may be separated from the fuse pattern 221 and the non-fuse pattern 223.

The fuse pattern 221 and the non-fuse pattern 223 may be spaced apart from a central portion in the width direction of the second part 220, and in different respective directions (e.g., in opposite directions). The fuse pattern 221 and the non-fuse pattern 223 may not overlap a central portion of the second part 220 in the width direction. For example, referring to FIG. 5, the fuse pattern 221 may be adjacent to one side of the second part 220 in the width direction, and the non-fuse pattern 223 may be adjacent to the other side of the second part 220 in the width direction.

The second part 220 may further include the connection area 224 and the second guide 225. The connection area 224 may connect the second part 220 to the third part 230. For example, referring to FIG. 4, the connection area 224 may be formed at an end of the second part 220 (e.g., the end facing the third part 230), and may be connected to the fuse pattern 221 and to the non-fuse pattern 223 of the circuit pattern P. The third part 230 may be connected to the upper surface of the connection area 224 such that the circuit pattern P and the busbar 130 may be electrically connected to each other.

The connection area 224 may include a connection portion 2241 and a protrusion 2242. For example, referring to FIG. 5, the connection portion 2241 may be formed at one end of the upper surface of the second part 220, and may be connected to the third part 230. Two protrusions 2242 may be formed on the side of the connection portion 2241 facing the circuit pattern P, and may be respectively connected to the fuse pattern 221 and the non-fuse pattern 223. For example, one protrusion 2242 may be connected to the extending portion 2212 of the fuse pattern 221.

The second guide 225 may define an area of the second part 220 where the circuit pattern P is formed. For example, referring to FIG. 4, the second guides 225 may be on both sides of the second part 220 in the width direction, respectively. The second guide 225 may protrude to be higher than the upper surface of the second part 220 where the circuit pattern P is arranged. The second guide 225 may extend from the first guide 212, or may be spaced apart from the first guide 212. The circuit pattern P may be between the two second guides 225. The second guide 225 may extend longer/further toward the third part 230 than the fuse pattern 221 and the non-fuse pattern 223, and may overlap the connection area 224 in the width direction of the second part 220.

The second part 220 may further include a safety area 226. For example, referring to FIG. 5, areas between the second guide 225 and the fuse pattern 221, and between the fuse pattern 221 and the block pattern 222, may be empty. The areas may form the safety area 226 that allows an arc, which may be generated if the fuse pattern 221 breaks, to be discharged to the surrounding area to avoid affecting the non-fuse pattern 223. The width of the safety area 226 may be (about) 30% to (about) 40% of a width Wt between the two second guides 225. The width of the safety area 226 may be the sum of the widths between the second guide 225 and the fuse pattern 221 and between the fuse pattern 221 and the block pattern 222. If the value is less than (about) 30% of the width Wt, the width of the safety area 226 is relatively low, and an arc generated if the fuse pattern 221 breaks may affect the non-fuse pattern 223. If the value is greater than (about) 40% of the width Wt, the widths of the circuit pattern P and the second part 220 may be excessively large.

The third part 230 may connect the circuit pattern P to the busbar 130. For example, at least a portion of the third part 230 may be connected to the second part 220 (e.g., the connection area 224). The third part 230 may contact the busbar 130. The third part 230 may detect a state, such as the temperature and/or voltage of the battery cell C through the busbar 130. Detected state information may be delivered to the BMS through the circuit pattern P via the second part 220 and the first part 210.

The third part 230 may include a cell contact portion 231 and a substrate contact portion 232. For example, referring to FIG. 4, a portion of the cell contact portion 231 may contact the upper surface of the busbar 130, and the other portion of the cell contact portion 231 may be on the second part 220. One or more substrate contact portions 232 may protrude on the side of the cell contact portion 231 facing the circuit pattern P. For example, referring to FIG. 4, two substrate contact portions 232 may be connected to the connection area 224.

The battery pack 10 may further include the lower plate 300, the upper plate 400, the frame 500, and the heat dissipation member 600.

The lower plate 300 may be at a lower portion of the battery pack 10, and may be supported by the frame 500. For example, the lower plate 300 may have a size corresponding to one or more battery modules 100, and may have a flat shape. The lower plate 300 may be below the battery module 100, and an edge thereof may be connected to the frame 500. For example, the lower plate 300 may be a cooling plate for cooling the battery pack 10. The lower plate 300 may include a material with high thermal conductivity (e.g., aluminum or copper), and may discharge heat generated in the battery module 100 to the outside. For example, the lower plate 300 may include a flow path through which a cooling fluid (e.g., a coolant or air) flows. The heat dissipation member 600 may be coated on the lower plate 300.

The upper plate 400 may be at an upper portion of the battery pack 10, and may be supported by the frame 500. For example, the upper plate 400 may have a size corresponding to one or more battery modules 100, and may have a flat shape. The upper plate 400 may be on the battery module 100, and an edge thereof may be connected to the frame 500. The upper plate 400 may be on the busbars 130 and the circuit board 200 of the battery module 100. For example, the upper plate 400 may be a fire reduction/prevention plate to reduce or prevent flame propagation in the battery pack 10. For example, the upper plate 400 may include mica. The upper plate 400 may allow a flame generated from one battery cell C to remain inside the lower holder 110 and the upper holder 120 without propagating to the outside of the battery module 100.

A fire extinguishing agent may be contained in the upper plate 400. If a fire occurs in the battery cell C, and if the internal pressure of the battery module 100 increases due to gas released from the battery cell C, a portion of the upper plate 400 may rupture such that the fire extinguishing agent therein may be ejected into the battery module 100.

The frame 500 may hold and support other components of the battery pack 10 (e.g., the battery module 100, the circuit board 200, the lower plate 300, upper plate 400, and the heat dissipation member 600). For example, referring to FIG. 2, the frame 500 may be a quadrangular frame having an internal space into which the battery module 100 is inserted. The frame 500 may support other components of the battery pack 10, and may allow the battery pack 10 to be mounted or installed in other applications, such as the vehicle 1.

The heat dissipation member 600 may be between the battery module 100 and the lower plate 300, and may transfer heat generated in the battery module 100 to the lower plate 300 or to the outside. For example, referring to FIG. 2, the heat dissipation member 600 may be located on the lower plate 300, and may contact the lower holder 110. For example, the heat dissipation member 600 may be a thermally conductive adhesive. The heat dissipation member 600 may correspond to each lower holder 110 included in the battery module 100. The heat dissipation member 600 may be coated on the lower plate 300 to transfer heat generated in the battery cell C to the lower plate 300 for cooling, and may dissipate heat from the battery module 100.

The present disclosure is described above with reference to the embodiments illustrated in the drawings, but the embodiments are only examples. Those of skill in the art will understand that various modifications and other equivalent embodiments may be derived from the embodiments. Therefore, the scope of the present disclosure should be determined by the appended claims, with functional equivalents thereof to be included therein.

In a battery pack, a non-fuse pattern may maintain electrical connection between a battery module and a circuit board, even if electrical noise or an external short circuit occurs in the circuit board, or if an abnormal current flows to cause a short circuit in a fuse pattern. Thus, even if the fuse pattern is opened, the circuit board may operate through the non-fuse pattern without the need to replace the circuit board.

It should be understood that embodiments described herein should be considered in a descriptive sense only, and not for purposes of limitation. Descriptions of aspects within each embodiment should typically be considered as available for other similar aspects in other embodiments. While one or more embodiments have been described with reference to the figures, it will be understood by those of ordinary skill in the art that various changes in form and details may be made therein without departing from the scope of the present disclosure as defined by the following claims, with functional equivalents thereof to be included therein.

## Claims

1. A battery pack (10) comprising:
a battery module (100) comprising battery cells, and busbars (130) electrically connecting respective ones of the battery cells; and
a circuit board (200) connected to the battery module (100), and comprising
a first part (210, 2111) comprising wires (211), and extending in a length direction of the battery module (100);
a second part (220, 2112) extending from the first part (210, 2111) in a direction crossing the first part (210, 2111), and comprising a circuit pattern comprising a fuse pattern (221) configured to be opened based on an abnormal current, and a non-fuse pattern (223) configured to maintain electrical connection with one or more of the busbars (130); and
a third part (230) extending from the second part (220, 2112), and connected to the busbars (130).

2. The battery pack (10) as claimed in claim 1, wherein a width of the fuse pattern (221) is less than a width of the non-fuse pattern (223).

3. The battery pack (10) as claimed in claim 2, wherein the width of the fuse pattern (221) is 20% to 60% of the width of the non-fuse pattern (223).

4. The battery pack (10) as claimed in one of the preceding claims , wherein the fuse pattern (221) and the non-fuse pattern (223) are spaced apart from a central portion of the second part (220, 2112) in a width direction of the second part (220, 2112).

5. The battery pack (10) as claimed in at least one of the preceding claims, wherein the second part (220, 2112) further comprises a connection area (224) at an end thereof that is connected to the fuse pattern (221), to the non-fuse pattern (223), and to the third part (230).

6. The battery pack (10) as claimed in at least one of the preceding claims, wherein the circuit pattern further comprises a block pattern (222) between the fuse pattern (221) and the non-fuse pattern (223) that is configured to block an arc generated due to the fuse pattern (221) being opened.

7. The battery pack (10) as claimed in claims 5 and 6, wherein the block pattern (222) is spaced apart from the fuse pattern (221), from the non-fuse pattern (223), and from the connection area (224), and is electrically separated from the wires (211).

8. The battery pack (10) as claimed in at least one of the preceding claims, wherein the first part (210, 2111) further comprises first guides (212) respectively on both sides thereof in a width direction of the first part (210, 2111),
wherein the second part (220, 2112) further comprises two second guides (225) respectively on both sides thereof in a width direction of the second part (220, 2112), and extending from or spaced apart from the first guides (212) with the circuit pattern between the two second guides.

9. The battery pack (10) as claimed in claim 8, wherein the first guides (212) protrude higher than an upper surface of the first part (210, 2111) on which the wires (211) are arranged, and
wherein the second guides (225) protrude higher than an upper surface of the second part (220, 2112) where the circuit pattern is arranged.

10. The battery pack (10) as claimed in one of claims 8 or 9, wherein an empty safety area (226) is defined between the second guides (225) and the fuse pattern (221), and between the fuse pattern (221) and the block pattern (222).

11. The battery pack (10) as claimed in claim 10, wherein a width of the safety area (226) is 30% to 40% of a width between the two second guides (225).

12. The battery pack (10) as claimed in claim 9, wherein the second guides (225) extend further toward the third part (230) than the fuse pattern (221) and the non-fuse pattern (223), and overlap the connection area (224) in the width direction of the second part (220, 2112).

13. The battery pack (10) as claimed in at least one of the preceding claims, wherein the fuse pattern (221) comprises:
a bent portion (2211) having a wavy shape; and
extending portions (2212) respectively connected to both ends of the bent portion (2211) in a length direction, and connecting the bent portion (2211) to the first part (210, 2111) and the third part (230), respectively.

14. The battery pack (10) as claimed in claim 13, wherein the bent portion (2211) has a shape in which convex portions and concave portions are continuous at equal intervals, and a distance between adjacent ridges is 1.5 times to 3 times a total width of the bent portion (2211).

15. The battery pack (10) as claimed in claim 13 or 14, wherein the bent portion (2211) of the fuse pattern (221) comprises a swellable material.
